# EUROPÄISCHE PATENTANMELDUNG

(11) **EP 3 144 651 A1**
(43) Veröffentlichungstag der Anmeldung: **22.03.2017**
(21) Anmeldenummer: 15185804.0
(22) Anmeldetag: 18.09.2015
(51) Int. Cl.: G01J 5/00, G01J 5/06, G01J 5/52, G01J 5/08, G01N 25/72, G01R 31/309

(54) **EMISSIONSABSCHIRMUNG UND VERFAHREN ZUR TEMPERATURMESSUNG**

(71) Anmelder: Weiss Umwelttechnik GmbH, 35447 Reiskirchen (DE)
(72) Erfinder: SCHLOSSER, Volker, 35305 Grünberg (DE)
(74) Vertreter: advotec.

(57) **Zusammenfassung**

Die Erfindung betrifft eine Emissionsabschirmung (13) für einen Prüfraum und einen Prüfraum (10), insbesondere Klimakammer oder dergleichen, wobei die Emissionsabschirmung in einem temperierbaren Prüfraum zwischenliegend einer Wärmebildkamera (20) und Prüfgut anordbar ist, derart, dass ein Gehäuse (23) der Wärmebildkamera gegenüber dem Prüfgut thermografisch abschirmbar ist, wobei die Emissionsabschirmung eine Blende ausbildet, durch die das Prüfgut mittels der Wärmebildkamera thermografisch aufnehmbar ist. Weiter betrifft die Erfindung ein Verfahren zur Temperaturmessung von Prüfgut (17) in einem Prüfraum (10) mittels einer Wärmebildkamera (20), wobei der Prüfraum mit dem Prüfgut temperiert wird, wobei das Prüfgut mittels der Wärmebildkamera thermografisch aufgenommen wird, wobei mittels eines Temperatursensors (24) an einem Emissionshintergrund (14) des Prüfraums, der relativ zur Wärmebildkamera hinter dem Prüfgut innerhalb des Prüfraums angeordnet ist, eine Temperatur des Emissionshintergrundes gemessen wird.

## Beschreibung

Die Erfindung betrifft eine Emissionsabschirmung für einen Prüfraum sowie ein Verfahren zur Temperaturmessung von Prüfgut in einem Prüfraum, insbesondere Klimakammer oder dergleichen, wobei die Emissionsabschirmung in einem temperierbaren Prüfraum zwischenliegend einer Wärmebildkamera und Prüfgut anordbar ist, derart, dass ein Gehäuse der Wärmebildkamera gegenüber dem Prüfgut thermografisch abschirmbar ist, wobei die Emissionsabschirmung eine Blende ausbildet, durch die das Prüfgut mittels der Wärmebildkamera thermografisch aufnehmbar ist.

Die aus dem Stand der Technik bekannten Prüfräume, Klimakammern, Klimaprüfschränke oder vergleichbare Einrichtungen zur Wärmebildmessung weisen regelmäßig stark reflektierende Wände und Einbauten auf, die eine genaue Wärmebildmessung, unter anderem auch aufgrund von geringen Abständen innerhalb des Prüfraums, erschweren. Die Wände des Prüfraums sowie die Einbauten erzeugen Spiegelungen auf das Prüfgut, die eine korrekte Wärmebildmessung verhindern. Daher ist es bekannt, Innenwände von Prüfräumen mit speziellen Lacken zu beschichten, die einen Emissionsgrad von nahezu 1 aufweisen. Dennoch kann dann immer noch auf Prüfgut mit einem vergleichsweise geringen Emissionsgrad eine eine Messung verfälschende Spiegelung erzeugt werden. Darüber hinaus erzeugt die im Prüfraum eingebaute Wärmebildkamera auf derartigem Prüfgut ein Abbild ihrer selbst. Die Wärmebildkamera muss, um ihre korrekte Funktion zu gewährleisten, auf einer Temperatur um Raumtemperatur, idealerweise bei 25 °C bzw. in einem Bereich von 10 bis 40 °C, temperiert werden. Werden dann beispielsweise Wärmebilder bei tiefen Temperaturen im Prüfraum mit einer entsprechend temperierten Wärmebildkamera bzw. einer entsprechenden Temperatur eines Schutzgehäuses der Wärmebildkamera aufgenommen, bildet sich die Wärmestrahlung des Schutzgehäuses auf einer Oberfläche des Prüfguts ab und verfälscht so eine Messung. Dieser Effekt tritt verstärkt in der Klimaprüftechnik auf, da mögliche Abstände zwischen einer Wärmebildkamera und einem Prüfgut aus Platzgründen im Prüfraum meist sehr gering sind. Gerade bei Prüfgut mit unterschiedlicher Oberfläche, wie beispielsweise bei einer bestückten Platine, weist das Prüfgut bzw. der Prüfling durch eine Vielzahl von Bauteilen Oberflächen mit sich sehr stark unterscheidenden Emissionsgraden auf. Da für eine vergleichsweise genaue Temperaturmessung über eine Bildaufnahme einer Wärmebildkamera immer auch der jeweilige Emissionsgrad einer Oberfläche des Prüfguts bekannt sein muss, gestaltet sich eine Messung verschiedener Oberflächenbereiche derartigen Prüfguts sehr aufwändig. Für eine Messung bei verschiedenen Temperaturen ist es stets erforderlich, die Wärmebildkamera zu kalibrieren. Gerade eine Messung von Prüfgut, welches Temperaturwechseln in einem Bereich zwischen -70 °C und Raumtemperatur ausgesetzt sein soll, ist daher mit nur großem Aufwand bei gleichzeitig nicht befriedigend genauen Messergebnissen durchzuführen.

Es ist daher Aufgabe der Erfindung, eine Emissionsabschirmung für einen Prüfraum, einen Prüfraum und ein Verfahren zur Temperaturmessung von Prüfgut vorzuschlagen, die bzw. das mit geringem Aufwand eine genaue Wärmebildmessung bei niedrigen Temperaturen ermöglicht.

Diese Aufgabe wird durch eine Emissionsabschirmung mit den Merkmalen des Anspruchs 1, einen Prüfraum mit den Merkmalen des Anspruchs 4 und ein Verfahren mit den Merkmalen des Anspruchs 12 gelöst.

Die erfindungsgemäße Emissionsabschirmung für einen Prüfraum, insbesondere Klimakammer oder dergleichen, ist in einem temperierbaren Prüfraum zwischenliegend einer Wärmebildkamera und Prüfgut anordbar, derart, dass ein Gehäuse der Wärmebildkamera gegenüber dem Prüfgut thermografisch abschirmbar ist, wobei die Emissionsabschirmung eine Blende ausbildet, durch die das Prüfgut mittels der Wärmebildkamera thermografisch aufnehmbar ist.

Die Emissionsabschirmung ist folglich innerhalb des Prüfraums angeordnet und so ausgebildet, dass sie möglichst schnell eine Prüfraumtemperatur annehmen kann. Darüber hinaus ist die Emissionsabschirmung bzw. das Emissionsschild zwischen dem Prüfgut und der Wärmebildkamera bzw. einem Schutzgehäuse der Wärmebildkamera so angeordnet, dass die Emissionsabschirmung von der Wärmebildkamera bzw. dem Schutzgehäuse thermisch entkoppelt ist. Insbesondere ist die Emissionsabschirmung nicht an ein Objektiv der Wärmebildkamera gekoppelt, sondern mit einem Abstand zu dem Objektiv so angeordnet, dass die Wärmebildkamera durch die Blende der Emissionsabschirmung hindurch das Prüfgut aufnehmen bzw. bildtechnisch erfassen kann. Dabei wird eine Projektion von Wärmestrahlung der Wärmebildkamera auf das Prüfgut durch die Emissionsabschirmung verhindert. Ausgehend von dem Prüfgut ist lediglich eine Objektivmitte bzw. eine Objektivöffnung durch die Blende hindurch sichtbar, wobei ein Objektivring bzw. das Schutzgehäuse vollständig von der Emissionsabschirmung überdeckt ist. So wird es möglich, auch bei vergleichsweise niedrigen Temperaturen im Prüfraum Wärmebildmessungen von dem Prüfgut anzufertigen, ohne dass diese durch eine Projektion von Wärmestrahlung der Wärmebildkamera auf das Prüfgut verfälscht werden. Dieser Vorteil ist bereits dann erzielbar, wenn eine Temperatur im Prüfraum unterhalb oder auch oberhalb einer Temperatur eines Schutzgehäuses der Wärmebildkamera liegt.

Vorteilhaft kann die Emissionsabschirmung einen Emissionsgrad von mindestens 0,9, bevorzugt von nahezu 1 aufweisen. Beispielsweise kann die Emissionsabschirmung mit einer Lackierung versehen sein, die diesen Emissionsgrad ausbildet. Die Emissionsabschirmung kann dann besonders wirkungsvoll eine mögliche Wärmestrahlung der Wärmebildkamera auf das Prüfgut abschirmen.

Die Emissionsabschirmung kann als eine Platte mit einer Blendenöffnung ausgebildet sein. Die Platte kann ein dünnes Metallblech sein, innerhalb dem eine runde Blendenöffnung der Blende ausgebildet ist. Eine derartige Emissionsabschirmung ist besonders einfach und kostengünstig herstellbar und kann leicht in einem Prüfraum angeordnet werden. Auch kann die Emissionsabschirmung besonders schnell eine im Prüfraum herrschende Temperatur annehmen, wenn es sich bei der Emissionsabschirmung um ein dünnes Blech handelt. Die Platte bzw. das dünne Blech kann in einer einfachen Ausführungsform vollkommen eben ausgebildet sein.

Der erfindungsgemäße Prüfraum, insbesondere Klimakammer oder dergleichen, ist temperierbar, gegenüber einer Umgebung abschließbar und dient zur Aufnahme von Prüfgut, wobei der Prüfraum begrenzende und temperaturisolierte Wände aufweist, wobei der Prüfraum eine Wärmebildkamera zur thermografischen Aufnahme von Prüfgut mit einem Gehäuse aufweist, wobei der Prüfraum eine erfindungsgemäße Emissionsabschirmung aufweist, die innerhalb des Prüfraums zwischen der Wärmebildkamera und Prüfgut angeordnet ist. Die temperaturisolierenden Wände umfassen Bodenwand, Deckenwand und Seitenwände des Prüfraums und der Prüfraum kann mittels einer Tür gegenüber der Umgebung dicht und temperaturisoliert abgeschlossen werden. Die Vorteile des erfindungsgemäßen Prüfraums betreffend wird auf die Vorteilsbeschreibung der erfindungsgemäßen Emissionsabschirmung verwiesen. Weitere Ausführungsformen des Prüfraums ergeben sich aus den auf den Vorrichtungsanspruch 1 rückbezogenen Unteransprüchen.

Weiter kann der Prüfraum einen Emissionshintergrund aufweisen, der relativ zur Wärmebildkamera hinter Prüfgut innerhalb des Prüfraums angeordnet sein kann. Der Emissionshintergrund kann dann zwischen dem Prüfgut und beispielsweise einer Seitenwand des Prüfraums in diesem angeordnet und befestigt sein. Vorteilhaft kann der Emissionshintergrund eine im Prüfraum herrschende Temperatur vergleichsweise schnell annehmen. Wenn der Emissionshintergrund hinsichtlich seiner Gestalt homogen bzw. möglichst gleichförmig ausgebildet ist, kann bei einer Wärmebildaufnahme von Prüfgut vor dem Emissionshintergrund das Prüfgut besonders gut erkennbar sein bzw. das Prüfgut kann leicht von dem Hintergrund unterschieden werden. Insbesondere bei Temperaturwechseln im Prüfraum kann sich das Prüfgut gegenüber dem thermisch homogenen Emissionshintergrund in einer Wärmebildaufnahme deutlich unterscheidbar abheben.

Besonders vorteilhaft ist es, wenn der Emissionshintergrund parallel zur Emissionsabschirmung in dem Prüfraum angeordnet ist. Das Prüfgut kann dann zwischen dem Emissionshintergrund und der Emissionsabschirmung angeordnet werden. Aufgrund der parallelen, thermisch homogenen Oberflächen von Emissionshintergrund und Emissionsabschirmung werden Spiegelungen bzw. eine Projektion von Wärmestrahlung auf das Prüfgut oder den Emissionshintergrund vermieden.

Der Emissionshintergrund kann einen Emissionsgrad von mindestens 0,9, bevorzugt von nahezu 1 aufweisen. Insbesondere kann der Emissionsgrad des Emissionshintergrundes mit dem Emissionsgrad der Emissionsabschirmung übereinstimmend ausgebildet sein.

Weiter kann der Emissionshintergrund als eine Platte ausgebildet sein. Dabei kann es sich, wie auch bei der Emissionsabschirmung, um ein dünnes Blech aus Metall handeln, welches vollkommen eben ausgebildet sein kann. Auch kann der Emissionshintergrund so groß ausgebildet sein, dass er eine Bildhintergrundebene bzw. ein Gesichtsfeld der Wärmebildkamera überdeckt. So kann sichergestellt werden, dass die Wärmebildkamera allein den Emissionshintergrund und das Prüfgut erfasst, ohne dass Wände der Prüfkammer oder andere Gegenstände oder Einbauten in einen thermografischen Erfassungsbereich der Wärmebildkamera hineinragen.

Eine Temperaturmessung mittels der Wärmebildkamera kann vereinfacht werden, wenn an dem Emissionshintergrund ein Temperatursensor angeordnet ist, wobei der Temperatursensor und die Wärmebildkamera mit einer Auswerteeinheit des Prüfraums gekoppelt sein können. Dann wird es möglich, mittels des Temperatursensors die tatsächliche Temperatur des Emissionshintergrundes zu erfassen, welche von einer Temperatur im Prüfraum abweichen kann. Wenn der Emissionsgrad des Emissionshintergrundes bekannt ist, kann dann die Wärmebildkamera während oder nach einer Messung kalibriert werden. Um eine Temperatur des Emissionshintergrundes zum Zeitpunkt einer Wärmebildaufnahme einfacher erfassen zu können, können der Temperatursensor und die Wärmebildkamera über die Auswerteeinheit miteinander so verbunden sein, dass eine gleichzeitige Erfassung und Zuordnung der jeweiligen Daten erfolgt.

Mittels einer Temperiervorrichtung des Prüfraums kann eine Temperatur in einem Temperaturbereich von -75 °C bis +180 °C, vorzugsweise -100 °C bis +200 °C, innerhalb des Prüfraums ausgebildet werden. Der Prüfraum ist dann für eine Vielzahl möglicher Temperaturmessungen in unterschiedlichsten Temperaturbereichen geeignet.

Bei dem erfindungsgemäßen Verfahren zur Temperaturmessung von Prüfgut in einem Prüfraum, insbesondere Klimakammer oder dergleichen, mittels einer Wärmebildkamera, wird der Prüfraum mit dem Prüfgut temperiert, wobei das Prüfgut mittels der Wärmebildkamera thermografisch aufgenommen wird, wobei mittels eines Temperatursensors an einem Emissionshintergrund des Prüfraums, der relativ zur Wärmebildkamera hinter dem Prüfgut innerhalb des Prüfraums angeordnet ist, eine Temperatur des Emissionshintergrundes gemessen wird.

Wesentlich bei dem Verfahren ist, dass ein Emissionsgrad des Emissionshintergrundes bekannt ist, sodass ein Emissionsgrad des Prüfguts über eine Wärmebildaufnahme der Wärmebildkamera bestimmt werden kann, wenn eine Temperatur des Prüfguts bekannt ist. Gleichwohl ist es möglich, über die Wärmebildaufnahme der Wärmebildkamera eine Temperatur des Prüfguts vergleichsweise genau zu bestimmen, wenn ein Emissionsgrad des Prüfguts bekannt ist. Weitere mögliche Ausführungsformen des Verfahrens ergeben sich aus den auf den erfindungsgemäßen Prüfraum rückbezogenen Unteransprüchen.

So kann mittels einer Auswerteeinheit des Prüfraums eine thermografische Aufnahme des Prüfguts und eine Temperatur des Emissionshintergrundes erfasst, gespeichert und/oder verarbeitet werden. Die Auswerteeinheit kann beispielsweise Mittel zur Datenverarbeitung aufweisen bzw. ein Computer sein, der die während einer Wärmebildaufnahme gemessene Temperatur des Emissionshintergrundes zusammen mit Wärmebildaufnahmen speichert. Eine Auswertung der Wärmebildaufnahmen ist dann jederzeit möglich. Alternativ kann aber auch vorgesehen sein, dass die Auswerteeinheit die Wärmebildaufnahmen unmittelbar auswertet bzw. verarbeitet. Eine Messung des Prüfguts kann dabei zyklisch erfolgen, wenn beispielsweise unterschiedliche Temperaturbereiche gemessen werden sollen.

Mittels der Auswerteeinheit kann aus einer gemessenen Temperatur und einem Emissionsgrad des Emissionshintergrundes ein Emissionsgrad des Prüfguts oder eine Temperatur des Prüfguts bestimmt werden. Dies ist unter der Voraussetzung möglich, dass der Emissionsgrad des Emissionshintergrundes bekannt ist. Als eine Referenz zur Bestimmung von Emissionsgrad oder Temperatur des Prüfguts durch die Wärmebildaufnahme der Wärmebildkamera kann immer der Emissionshintergrund mit dem bekannten Emissionsgrad und der bekannten Temperatur herangezogen werden. Eine genaue Berechnung des Emissionsgrades oder der Temperatur des Prüfguts kann beispielsweise mittels bekannter Bildverarbeitungstechniken erfolgen.

Weiter kann ein Emissionsgrad oder eine Temperatur von einzelnen Pixeln oder Gruppen von Pixeln einer thermografischen Aufnahme des Prüfguts der Wärmebildkamera bestimmt werden. Insbesondere bei Prüfgut, welches sich aus unterschiedlichen Bauteilen zusammensetzt, wie beispielsweise eine bestückte Platine, kann dann jeweils ein Emissionsgrad oder eine Temperatur der einzelnen Bauteile bestimmt werden. Dies kann beispielsweise mittels Bildverarbeitung der Wärmebildaufnahme erfolgen, wobei die jeweils dem Bauteil zugehörigen Pixel oder Gruppen von Pixeln als dem jeweiligen Bauteil zugehörig definiert und ausgewertet werden.

Auch kann ein Emissionsgrad oder eine Temperatur des Prüfguts nach oder während einer Aufnahme des Prüfguts der Wärmebildkamera bestimmt werden. Da alle relevanten Daten in der Auswerteeinheit erfasst bzw. gespeichert werden können, kann auch während oder nach der Aufnahme mit der Wärmebildkamera die Wärmebildkamera kalibriert bzw. die Wärmebildaufnahme korrigiert werden. Prinzipiell ist es jedoch auch möglich, die Wärmebildkamera vor einer Wärmebildaufnahme dadurch zu kalibrieren, dass mit der Wärmebildkamera allein der Emissionshintergrund bei der für eine nachfolgende Messung vorgesehenen Temperatur aufgenommen wird. Die Kalibrierung kann dann mittels der Auswerteeinheit oder je nach Ausführung der Wärmebildkamera direkt an der Wärmebildkamera erfolgen.

Noch genauere Messergebnisse können erzielt werden, wenn ein Gehäuse der Wärmebildkamera gegenüber dem Prüfgut mittels einer Emissionsabschirmung abgeschirmt wird.

Weitere vorteilhafte Ausführungsformen des Verfahrens ergeben sich aus den auf den Vorrichtungsanspruch 1 rückbezogenen Unteransprüchen.

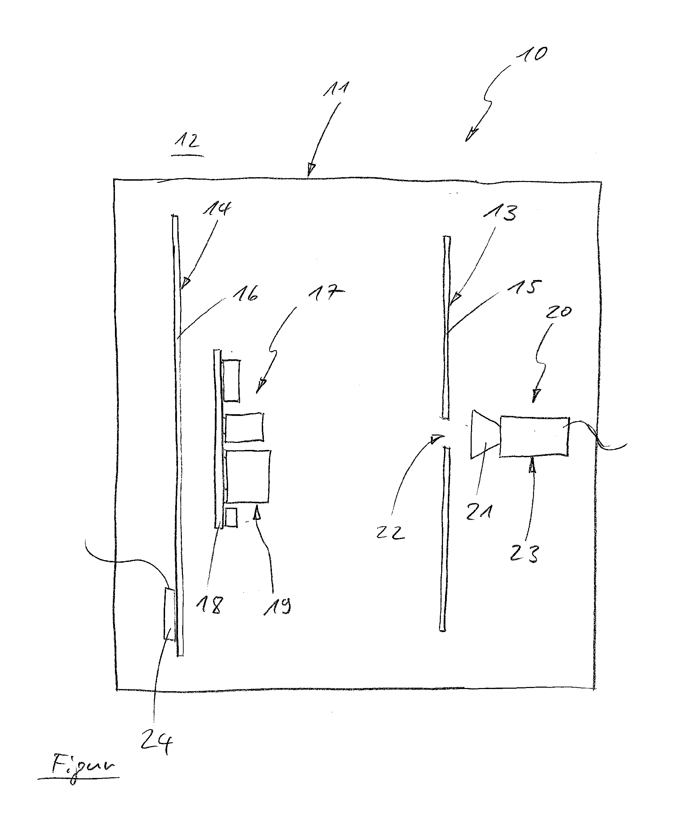

Nachfolgend wird die Erfindung unter Bezugnahme auf die beigefügte Zeichnung näher erläutert.

Die **Figur** zeigt eine schematische Darstellung eines Prüfraums 10, der temperierbar ist und durch temperaturisolierte Wände 11 gegenüber einer Umgebung 12 abgeschlossen ist. Innerhalb des Prüfraums 10 ist eine Emissionsabschirmung 13 und ein Emissionshintergrund 14 von den Wänden 11 beabstandet angeordnet. Die Emissionsabschirmung 13 und der Emissionshintergrund 14 sind jeweils aus aus Metall bestehenden Blechen 15 bzw. 16 gebildet, die mit einem hier nicht dargestellten Lack beschichtet sind. Der jeweilige Emissionsgrad der Bleche 15 und 16 liegt in einem Bereich nahe 1. Die Bleche 15 und 16 sind relativ zueinander parallel angeordnet, wobei zwischen den Blechen 15 und 16 in relativer Nähe zum Emissionshintergrund 14 Prüfgut 17 im Prüfraum 10 angeordnet ist. Das Prüfgut 17 umfasst eine Platine 18 mit verschiedenen Bauteilen 19. Weiter ist im Prüfraum 10 eine Wärmebildkamera 20 mit einem Objektiv 21 angeordnet. In dem Blech 15 bzw. der Emissionsabschirmung 13 ist eine Blendenöffnung 22 ausgebildet, sodass durch die Blendenöffnung 22 mittels der Wärmebildkamera 20 eine thermografische Aufnahme des Prüfguts 17 erfolgen kann. Innerhalb der thermografischen Aufnahme sind dann das Prüfgut 17 und der Emissionshintergrund 14 sichtbar bzw. erfassbar. Eine mögliche Reflektion eines Gehäuses 23 der Wärmebildkamera 20 auf das Prüfgut 17 wird durch die Emissionsabschirmung 13 verhindert. Weiter ist an dem Emissionshintergrund 14 bzw. dem Blech 16 rückseitig ein Temperatursensor 24 angebracht, über den eine Temperatur des Blechs 16 fortlaufend erfasst werden kann. Mittels einer hier nicht dargestellten Auswerteeinheit kann aufgrund des bekannten Emissionsgrades des Emissionshintergrundes 14 und der mit dem Temperatursensor 24 gemessenen Temperatur in einer Wärmebildaufnahme der Wärmebildkamera 20 eine Referenz bzw. eine Referenzfläche in der Wärmebildaufnahme geschaffen werden, über die eine Temperatur oder ein Emissionsgrad des Prüfguts 17 vergleichsweise genau bei jeder beliebigen Prüftemperatur bestimmt werden kann. Dabei werden die Bildbereiche der Wärmebildaufnahme des Emissionshintergrundes 14 mit den Bildbereichen bzw. Pixeln oder Gruppen von Pixeln des Prüfguts 17 bildverarbeitungstechnisch verglichen.

## Patentansprüche

1. Emissionsabschirmung (13) für einen Prüfraum, insbesondere Klimakammer oder dergleichen, wobei die Emissionsabschirmung in einem temperierbaren Prüfraum (10) zwischenliegend einer Wärmebildkamera (20) und Prüfgut (17) anordbar ist, derart, dass ein Gehäuse (23) der Wärmebildkamera gegenüber dem Prüfgut thermografisch abschirmbar ist, wobei die Emissionsabschirmung eine Blende ausbildet, durch die das Prüfgut mittels der Wärmebildkamera thermografisch aufnehmbar ist.

2. Emissionsabschirmung nach Anspruch 1,
**dadurch gekennzeichnet,**
**dass** die Emissionsabschirmung (13) einen Emissionsgrad von mindestens 0,9, bevorzugt von nahezu 1 aufweist.

3. Emissionsabschirmung nach Anspruch 1 oder 2,
**dadurch gekennzeichnet,**
**dass** die Emissionsabschirmung (13) als eine Platte mit einer Blendenöffnung (22) ausgebildet ist.

4. Prüfraum (10), insbesondere Klimakammer oder dergleichen, wobei der Prüfraum temperierbar ist, gegenüber einer Umgebung (12) abschließbar ist und zur Aufnahme von Prüfgut (17) dient, wobei der Prüfraum begrenzende und temperaturisolierte Wände (11) aufweist, wobei der Prüfraum eine Wärmebildkamera (20) zur thermografischen Aufnahme von Prüfgut mit einem Gehäuse (23) aufweist,
**dadurch gekennzeichnet,**
**dass** der Prüfraum eine Emissionsabschirmung (13) nach einem der vorangehenden Ansprüche aufweist, die innerhalb des Prüfraums zwischen der Wärmebildkamera und Prüfgut angeordnet ist.

5. Prüfraum nach Anspruch 4,
**dadurch gekennzeichnet,**
**dass** der Prüfraum (10) einen Emissionshintergrund (14) aufweist, der relativ zur Wärmebildkamera hinter Prüfgut innerhalb des Prüfraums angeordnet ist.

6. Prüfraum nach Anspruch 5,
**dadurch gekennzeichnet,**
**dass** der Emissionshintergrund (14) parallel zur Emissionsabschirmung (13) in dem Prüfraum (10) angeordnet ist.

7. Prüfraum nach Anspruch 5 oder 6,
**dadurch gekennzeichnet,**
**dass** der Emissionshintergrund (14) einen Emissionsgrad von mindestens 0,9, bevorzugt von nahezu 1 aufweist.

8. Prüfraum nach einem der Ansprüche 5 bis 7,
**dadurch gekennzeichnet,**
**dass** der Emissionshintergrund (14) als eine Platte ausgebildet ist.

9. Prüfraum nach einem der Ansprüche 5 bis 8,
**dadurch gekennzeichnet,**
**dass** der Emissionshintergrund (14) so groß ausgebildet ist, dass er einen Bildhintergrund der Wärmebildkamera (20) überdeckt.

10. Prüfraum nach einem der Ansprüche 5 bis 9,
**dadurch gekennzeichnet,**
**dass** an dem Emissionshintergrund (14) ein Temperatursensor (24) angeordnet ist, wobei der Temperatursensor und die Wärmebildkamera (20) mit einer Auswerteeinheit des Prüfraums (10) gekoppelt sind.

11. Prüfraum nach einem der Ansprüche 4 bis 10,
**dadurch gekennzeichnet,**
**dass** mittels einer Temperiervorrichtung des Prüfraums (10) eine Temperatur in einem Temperaturbereich von -75 °C bis +180 °C, vorzugsweise -100 °C bis +200 °C, innerhalb des Prüfraums ausbildbar ist.

12. Verfahren zur Temperaturmessung von Prüfgut (17) in einem Prüfraum (10), insbesondere Klimakammer oder dergleichen, mittels einer Wärmebildkamera (20), wobei der Prüfraum mit dem Prüfgut temperiert wird, wobei das Prüfgut mittels der Wärmebildkamera thermografisch aufgenommen wird,
**dadurch gekennzeichnet,**
**dass** mittels eines Temperatursensors (24) an einem Emissionshintergrund (14) des Prüfraums, der relativ zur Wärmebildkamera hinter dem Prüfgut innerhalb des Prüfraums angeordnet ist, eine Temperatur des Emissionshintergrundes gemessen wird.

13. Verfahren nach Anspruch 12,
**dadurch gekennzeichnet,**
**dass** mittels einer Auswerteeinheit des Prüfraums (10) eine thermografische Aufnahme des Prüfguts (17) und eine Temperatur des Emissionshintergrundes (14) erfasst, gespeichert und/oder verarbeitet wird.

14. Verfahren nach Anspruch 13,
**dadurch gekennzeichnet,**
**dass** mittels der Auswerteeinheit aus einer gemessenen Temperatur und einem Emissionsgrad des Emissionshintergrundes (14) ein Emissionsgrad oder eine Temperatur des Prüfguts (17) bestimmt wird.

15. Verfahren nach Anspruch 14,
**dadurch gekennzeichnet,**
**dass** ein Emissionsgrad oder eine Temperatur von einzelnen Pixeln oder Gruppen von Pixeln einer thermografischen Aufnahme der Wärmebildkamera (20) bestimmt wird.

16. Verfahren nach Anspruch 14 oder 15,
**dadurch gekennzeichnet,**
**dass** ein Emissionsgrad oder eine Temperatur des Prüfguts (17) nach oder während einer Aufnahme der Wärmebildkamera (20) bestimmt wird.

17. Verfahren nach einem der Ansprüche 13 bis 16,
**dadurch gekennzeichnet,**
**dass** mittels der Auswerteeinheit die Wärmebildkamera (20) vor, wärend oder nach einer thermografischen Aufnahme kalibriert wird.

18. Verfahren nach einem der Ansprüche 12 bis 17,
**dadurch gekennzeichnet,**
**dass** ein Gehäuse (23) der Wärmebildkamera (20) gegenüber dem Prüfgut (17) mittels einer Emissionsabschirmung (13) abgeschirmt wird.
